(19) Europäisches Patentamt
European Patent Office
Office européen des brevets

(11) Veröffentlichungsnummer : **0 132 710**
**B1**

(12) # EUROPÄISCHE PATENTSCHRIFT

(45) Veröffentlichungstag der Patentschrift : **21.01.87**

(51) Int. Cl.$^4$ : **G 03 F 7/10**, G 03 F 7/26

(21) Anmeldenummer : **84108186.2**

(22) Anmeldetag : **12.07.84**

(54) **Zur Herstellung von Reliefbildern oder Resistmustern geeignetes lichtempfindliches Aufzeichnungsmaterial.**

(30) Priorität : **20.07.83 DE 3326036**

(43) Veröffentlichungstag der Anmeldung : **13.02.85 Patentblatt 85/07**

(45) Bekanntmachung des Hinweises auf die Patenterteilung : **21.01.87 Patentblatt 87/04**

(84) Benannte Vertragsstaaten : **BE CH DE FR GB IT LI NL**

(56) Entgegenhaltungen :
**EP-A- 0 019 770**
**EP-A- 0 074 073**
**GB-A- 2 042 550**

(73) Patentinhaber : **BASF Aktiengesellschaft**
**Carl-Bosch-Strasse 38**
**D-6700 Ludwigshafen (DE)**

(72) Erfinder : **Leyrer, Reinhold, J. Dr.**
**Menzelstrasse 4**
**D-6700 Ludwigshafen (DE)**
Erfinder : **Henne, Andreas, Dr.**
**Adolf-Kolping-Strasse 137 a**
**D-6730 Neustadt (DE)**
Erfinder : **Ochs, Wolfram, Dr.**
**Hans-Willmann-Strasse 6**
**D-6706 Wachenheim (DE)**
Erfinder : **Schupp, Hans, Dr.**
**Gartenweg 10**
**D-6706 Wachenheim (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

EP 0 132 710 B1

**Beschreibung**

Die Erfindung betrifft ein lichtempfindliches, wahlweise positiv oder negativ arbeitendes Aufzeichnungsmaterial mit einer auf einem dimensionsstabilen Träger aufgebrachten lichtempfindlichen, härtbaren Schicht, welche als lichtempfindliche Komponente eine aromatische und/oder hereroaromatische o-Nitrocarbinolestergruppierungen aufweisende Verbindung und als härtende Komponente eine vernetzend wirkende Verbindung mit mindestens zwei reaktiven Gruppen enthält, die unter dem Einfluß von Wärme mit Carboxyl-Gruppen unter Bildung einer kovalenten chemischen Bindung zu reagieren vermögen. Die Erfindung betrifft des weiteren positiv bzw. negativ arbeitende Verfahren zur Herstellung von Reliefbildern oder Resistmustern mittels dieser lichtempfindlichen Aufzeichnungsmaterialien.

In der DE-B-23 09 062 sowie den älteren Patentanmeldungen DE-A-32 31 145 und DE-A-32 31 147 werden negativ und positiv arbeitende Verfahren zur Herstellung von Reliefbildern oder Resistmustern mittels lichtempfindlicher Aufzeichnungsmaterialien beschrieben, deren lichtempfindliche Schicht eine Verbindung mit mindestens zwei aromatischen und/oder heteroaromatischen o-Nitrocarbinolestergruppierungen sowie eine vernetzend wirkende Verbindung mit mindestens zwei gegenüber Carboxyl-Gruppen reaktiven Gruppen, beispielsweise Di- oder Polyepoxide, enthält. Bei den negativ arbeitenden Verfahren wird die lichtempfindliche, härtbare Schicht der Aufzeichnungsmaterialien nach einer bildmäßigen Belichtung mit aktinischem Licht in den belichteten Bereichen selektiv thermisch gehärtet und vernetzt, worauf die unbelichteten, nicht vernetzten Schichtanteile mit einem geeigneten Entwicklerlösungsmittel ausgewaschen werden. Wird die reliefbildende Schicht nach der selektiven thermischen Härtung noch einmal vollflächig mit aktinischem Licht nachbelichtet, so können für die Entwicklung der Reliefbilder und Resistmuster wäßrige Entwicklerlösungsmittel eingesetzt werden. Zur Herstellung von positiven Reliefbildern oder Resistmustern wird die lichtempfindliche, härtbare Schicht der Aufzeichnungsmaterialen nach der bildmäßigen Belichtung mit aktinischem Licht zunächst mit einem wäßrigen Entwicklerlösungsmittel unter Entfernung der belichteten Schichtanteile ausgewaschen, worauf anschließend die ursprünglich nicht belichteten, verbleibenden Bereiche der Schicht vollflächig mit aktinischem Licht nachbelichtet und thermisch gehärtet werden.

Gemäß der DE-B-23 09 062 kann in dem beschriebenen negativ arbeitenden Verfahren die selektive thermische Härtung der bildmäßig belichteten Schichtanteile bei Temperaturen bis zu 160 °C erfolgen. Hierbei wird zwar eine für die Entwicklung der Reliefbilder oder Resistmuster hinreichende Löslichkeitsdifferenzierung in der lichtempfindlichen, härtbaren Schicht erreicht, die nach der Entwicklung verbleibenden Reliefbilder oder Resistmuster sind aber in ihrer physikalischen und insbesondere chemischen Stabilität und Beständigkeit für viele Anwendungszwecke, insbesondere bei Einsatz von aggressiven Galvano- oder Ätzbädern, völlig unzureichend. Zudem werden bei Härtungstemperaturen über 130 bis 150 °C die Flankenstrukturen der erzeugten Reliefbilder oder Resistmuster sehr nachteilig beeinflußt. Auch kann, wenn die lichtempfindliche, härtbare Schicht der Aufzeichnungsmaterialien auf einem thermisch empfindlichen Substrat, beispielsweise Leiterbahnen oder einem Substrat mit dünnen, mehrlagigen Metallschichten, aufgebracht ist, bei höheren Härtungstemperaturen das Substrat in Mitleidenschaft gezogen werden.

In den älteren Patentanmeldungen DE-A-32 31 145 und DE-A-32 31 147 ist vorgeschlagen worden, den lichtempfindlichen, härtbaren Schichten der Aufzeichnungsmaterialien basische oder saure Katalysatoren für die thermische Härtung zuzusetzen. Hierdurch können unter Vermeidung hoher Härtungstemperaturen auch bei Verwendung von wärmeempfindlichen Substraten Reliefbilder oder Resistmuster mit hoher physikalischer und chemischer Stabilität und Beständigkeit erhalten werden. Die Lagerstabilität dieser Aufzeichnungsmaterialien ist jedoch noch nicht befriedigend.

Ferner sind lagerstabile, härtbare Zusammensetzungen bekannt, die neben einer härtbaren Verbindung, beispielsweise einem Epoxidharz, einen thermisch oder photochemisch aktivierbaren Katalysator für die Härtung enthalten (vgl. z. B. DE-C-25 59 879, DE-A-23 61 141, EP-A-74 073). Diese härtbaren Zusammensetzungen werden vornehmlich zur Herstellung von Überzügen und Formkörpern verwendet. Bei Einsatz dieser bekannten härtbaren Epoxidharzzusammensetzungen für die Herstellung von Reliefbildern oder Resistmustern kann jedoch nicht mit wäßrigen Auswaschlösungen entwickelt werden. Ferner besitzen Aufzeichnungsmaterialien aus solchen härtbaren Epoxidharzzusammensetzungen in aller Regel nicht die angestrebten anwendungstechnischen Eigenschaften, beispielsweise bezüglich des Belichtungsverhaltens, Verarbeitungsspielraumes, der Ausbildung der Reliefstruktur etc.

Aufgabe der vorliegenden Erfindung war es, ein lichtempfindliches Aufzeichnungsmaterial für die Herstellung von Reliefbildern oder Resistmustern aufzuzeigen, welches bei guter Lagerstabilität gleichzeitig gute Belichtungseigenschaften und einen guten Verarbeitungsspielraum nach der bildmäßigen Belichtung besitzt, mit wäßrigen Entwicklerlösungsmitteln entwickelbar ist, auch bei Verwendung von thermisch empfindlichen Substraten als Trägermaterialien, wie beispielsweise Leiterbahnen oder dünnschichtigen, mehrlagigen Metallsubstraten, die Herstellung von Reliefbildern und Resistmustern gestattet, welche eine ausgezeichnete Reliefstruktur, gute thermischen Stabilität, hohe mechanischen Festigkeit und hohe Beständigkeit selbst gegenüber aggressiven Prozeßchemikalien aufweisen.

Es wurde nun gefunden, daß diese Aufgabe gelöst wird, wenn lichtempfindliche Aufzeichnungsmaterialien der eingangs genannten Art mit einer lichtempfindlichen härtbaren Schicht, die eine Verbindung

mit mindestens zwei aromatischen und/oder heteroaromatischen o-Nitrocarbinolestergruppierungen und eine vernetzend wirkende Verbindung mit mindestens zwei, unter dem Einfluß von Wärme gegenüber Carboxyl-Gruppen reaktiven Gruppen enthält, in der lichtempfindlichen, härtbaren Schicht einen in verkappter, nicht aktiver Form vorliegenden Katalysator enthält, der photochemisch und/oder thermisch aktivierbar ist.

Gegenstand der Erfindung ist dementsprechend ein für die Herstellung von Reliefbildern oder Resistmustern geeignetes lichtempfindliches Aufzeichnungsmaterial mit einer auf einem dimensionsstabilen Träger aufgebrachten, vorzugsweisen festen, lichtempfindlichen, härtbaren Schicht (S), die enthält

a) eine Verbindung mit mindestens zwei aromatischen und/oder heteroaromatischen o-Nitrocarbinolestergruppierungen der allgemeinen Formel (I)

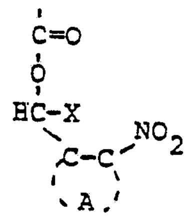

(I)

worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 Kohlenstoffatomen oder einen gegebenenfalls substituierten Aryl- oder Aralkylrest bedeuten,

b) eine vernetzend wirkende Verbindung mit mindestens zwei reaktiven Gruppen, die unter dem Einfluß von Wärme mit —COOH-Gruppen unter Bildung einer kovalenten chemischen Bindung zu reagieren vermögen,

c) mindestens einen Katalysator für die Reaktion der vernetzend wirkenden Verbindung (b) mit —COOH-Gruppen enthaltenden Verbindungen sowie gegebenenfalls

d) übliche Zusatz- und/oder Hilfsstoffe.

Das lichtempfindliche Aufzeichnungsmaterial ist dadurch gekennzeichnet, daß als Komponente (c) ein in verkappter, nicht aktiver Form vorliegender Katalysator enthalten ist, der photochemisch und/oder thermisch aktivierbar ist.

Gegenstand der Erfindung sind weiterhin spezielle Ausgestaltungsformen dieser lichtempfindlichen Aufzeichnungsmaterialien sowie Verfahren zur Herstellung von Reliefbildern oder Resistmustern mittels dieser Aufzeichnungsmaterialien entsprechend der nachfolgenden detaillierten Beschreibung.

Die Wahl des Trägers für die lichtempfindliche, härtbare Schicht (S) richtet sich vornehmlich nach dem Anwendungszweck der lichtempfindlichen Aufzeichnungsmaterialien und der damit herzustellenden Reliefbilder oder Resistmuster. Als dimensionsstabile Träger kommen beispielsweise metallische, metalloxidische oder keramische Untergründe, aber auch Filme, Folien oder Platten aus polymeren Substanzen in Betracht. So werden beispielsweise für die Herstellung von Ätz- oder Galvanoresisten als Träger Kupferbleche oder kupferkaschierte Substrate verwendet. Für die Herstellung von Dünnschichtschaltungen werden als Trägermaterial insbesondere Keramiksubstrate, die mit metallischen oder metalloxidischen Schichten beschichtet sind, oder Halbleiterelemente verarbeitet. Zur Herstellung von Reliefbildern und Druckplatten, sowie insbesondere von Offsetdruckplatten, können als Träger Kunststoffolien, z. B. aus Polyestern, oder Metallträger, z. B. Stahl- oder Aluminium-Bleche, eingesetzt werden. Insbesondere für die Herstellung von Offset-Druckplatten können die Kunststoffolien auch metallisch bedampft sein und die Stahl- oder Aluminium-Bleche mechanisch oder elektrochemisch aufgerauht sein und/oder eine anodisch erzeugte Oxidschicht besitzen. Für die Herstellung einer Lötstoppmaske kann die lichtempfindliche, härtbare Schicht (S) z. B. auf das Schaltbild einer gedruckten Schaltung als Träger aufgebracht werden. Für die Herstellung von Schichtübertragungsmaterialien oder Trockenfilmresisten kommen als Träger insbesondere Kunststoffolien, beispielsweise aus Polyethylenterephthalat oder Polybutylenterephthalat, in Betracht. Die lichtempfindliche, härtbare Schicht (S) kann auf das Trägermaterial nach den bekannten Auftragstechniken entweder aus Lösung oder trocken nach den üblichen Laminierverfahren aufgebracht werden.

Die lichtempfindliche, härtbare Schicht (S) der erfindungsgemäßen Aufzeichnungsmaterialien enthält als Komponente (a) eine Verbindung mit mindestens zwei aromatischen und/oder heteroaromatischen o-Nitrocarbinolestergruppierungen der allgemeinen Formel (I),

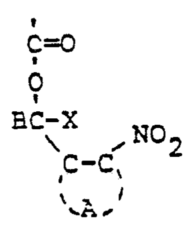

(I)

worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 C-Atomen oder einen gegebenenfalls substituierten Aryl- oder Aralkylrest bedeuten.

Als Komponente (a) kommen dabei die gebräuchlichen und bekannten o-Nitrocarbinolestergruppierungen enthaltenden niedermolekularen und/oder hochmolekularen Verbindungen in Betracht, wie sie beispielsweise in der DE-A-21 50 691, der DE-A-29 22 746, der DE-B-23 09 062, der DE-A-32 31 145 und der DE-A-32 31 147 beschrieben sind. Beispiele für das aromatische oder heteroaromatische Ringsystem A mit der o-ständigen Nitrogruppe, welches ein- oder mehrkernig sein kann, sind neben Naphthalin, Anthracen, Anthrachinon oder Phenanthren insbesondere das unsubstituierte oder substituierte Benzol. Als Substituenten für das aromatische Ringsystem A kommen neben der Nitrogruppe in o-Stellung beispielsweise Alkylreste mit 1 bis 8 C-Atomen, Alkoxyreste mit 1 bis 6 C-Atomen, Halogene, wie Chlor oder Brom, Nitro-, Amino-, Nitril- oder Sulfo-Gruppen in Betracht. Als Beispiel für heteroaromatische Ringsysteme sei der Pyridinrest genannt. Zu den bevorzugten o-Nitrocarbinolen, die den o-Nitrocarbinolestergruppierungen der allgemeinen Formel (I) zugrunde liegen, gehören beispielsweise o-Nitrobenzylalkohol, 2-Nitro-6-chlor-benzylalkohol, 2-Nitro-4-Cyanobenzylalkohol, 2-Nitro-4,5-dimethoxybenzylalkohol, alpha-Methyl-o-nitrobenzylalkohol, alpha-Phenyl-o-nitrobenzylalkohol, alpha-(o-Nitrophenyl)-o-nitrobenzylalkohol und 2-Nitro-3-hydroxymethylpyridin.

Zu den niedermolekularen Estern, die zwei oder mehr Estergruppierungen der allgemeinen Formel (I) enthalten und als Komponente (a) in der lichtempfindlichen, härtbaren Schicht (S) enthalten sein können, gehören insbesondere die Di- und/oder Polyester von Di- und/oder Polycarbonsäuren mit aromatischen und/oder heteroaromatischen o-Nitrocarbinolen der in Rede stehenden Art. Beispiele für niedermolekulare Di- und Polycarbonsäuren, die solchen Estern zugrunde liegen können, sind Oxalsäure, Malonsäure, Adipinsäure, Maleinsäure, Fumarsäure, Crotonsäure, Terephthalsäure, Trimellithsäure und Trimesinsäure. Im Falle des Einsatzes von niedermolekularen Estern der in Rede stehenden Art als Komponente (a) enthält die lichtempfindliche, härtbare Schicht (S) vorteilhaft noch ein mit diesen Estern verträgliches polymeres Bindemittel, wobei sich hierfür z. B. Acrylat- und/oder Methacrylat-Polymerisate besonders bewährt haben. Als polymere Bindemittel kommen auch die nachfolgend bei der Komponente (b) beschriebenen, hochmolekularen, vernetzend wirkenden Verbindungen mit gegenüber Carboxylgruppen reaktiven Gruppen in Betracht. Die Menge der niedermolekularen Ester mit den o-Nitrocarbinolestergruppierungen der Formel (I) in der lichtempfindlichen, härtbaren Schicht (S) wird so bemessen, daß die Schicht (S) nach der bildmäßigen Belichtung mit den Entwicklerlösungsmitteln auswaschbar ist und daß der angestrebte Vernetzungsgrad bei der thermischen Härtung der Reliefbilder oder Resistmuster erreicht wird. Hierzu ist es im allgemeinen hinreichend, wenn in der lichtempfindlichen, härtbaren Schicht (S) 0,5 bis 30 Gewichtsprozent, insbesondere 3 bis 15 Gewichtsprozent, der aromatischen und/oder heteroaromatischen o-Nitrocarbinolestergruppierungen der Formel (I), gerechnet als —COOH—, bezogen auf die lichtempfindliche, härtbare Schicht (S), enthalten sind.

Besonders vorteilhaft sind als Komponente (a) in der lichtempfindlichen, härtbaren Schicht (S) die Polymeren mit einem Molekulargewicht > 500, welche mindestens 5 Gewichtsprozent, bezogen auf das Molekulargewicht des Polymeren, aromatische und/oder heteroaromatische o-Nitrocarbinolestergruppierungen der allgemeinen Formel (I) im Molekül gebunden enthalten. Als das die o-Nitrocarbinolestergruppierungen tragende Polymer kommt zweckmäßigerweise eine organische Polycarbonsäure in Betracht, deren Carboxylgruppen mit den aromatischen und/oder heteroaromatischen o-Nitrocarbinolen verestert sind. Bei den organischen Polycarbonsäuren handelt es sich im allgemeinen um Homo- oder Copolymere von ethylenisch ungesättigten Mono- oder Dicarbonsäuren mit 3 bis 6 C-Atomen, insbesondere um Homo- oder Copolymerisate von Acrylsäure, Methacrylsäure, Maleinsäure, Fumarsäure oder Crotonsäure. Als Comonomeren kommt dabei Ethylen, Styrol und den $C_1$-$C_8$-Alkylestern der obengenannten ethylenisch ungesättigten Carbonsäuren besondere Bedeutung zu.

Es sei darauf hingewiesen, daß zur Erzielung einer guten Dunkellagerstabilität praktisch alle Carboxylgruppen der die o-Nitrocarbinolestergruppierungen tragenden Polycarbonsäure verestert sein oder zumindest in einer Form vorliegen müssen, in der sie mit den reaktiven Gruppen der vernetzend wirkenden Komponente (b) nicht direkt reagieren können. Andernfalls besteht die Gefahr einer zumindest teilweisen vorzeitigen Vernetzung und Härtung, wodurch die Aufzeichnungsmaterialien nur beschränkt einsatzfähig sein würden. Die Menge an o-Nitrocarbinolestergruppierungen der Formel (I) in den Polymeren kann in weiten Grenzen schwanken und wird im allgemeinen so eingestellt, daß die lichtempfindliche, härtbare Schicht (S) nach der Belichtung wasserentwickelbar ist.

Die lichtempfindliche, härtbare Schicht (S) der erfindungsgemäßen Aufzeichnungsmaterialien enthält auch eine vernetzend wirkende Verbindung mit mindestens zwei reaktiven Gruppen, die unter dem Einfluß von Wärme mit Carboxylgruppen unter Bildung einer kovalenten chemischen Bindung zu reagieren vermögen (Komponente b). Die Reaktivität dieser vernetzend wirkenden reaktiven Gruppen ist so auf die Verfahrensbedingungen bei der Verarbeitung der lichtempfindlichen Aufzeichnungsmaterialien, wie z. B. Belichtungs- und Entwicklungsdauer und -temperatur sowie Verarbeitungsspielraum, abzustellen, daß ein einwandfreies Verarbeiten der lichtempfindlichen Aufzeichnungsmaterialien zu den Reliefbildern oder Resistmustern gewährleistet bleibt. Vorzugsweise werden daher solche vernetzend wirkenden Verbindungen in der lichtempfindlichen, härtbaren Schicht (S) eingesetzt, die erst in der Wärme bei erhöhter Temperatur, beispielsweise bei Temperaturen oberhalb 40 °C, in merklicher

Geschwindigkeit mit den freien Carboxyl-Gruppen reagieren. Als Komponente (b) geeignete vernetzend wirkende Verbindungen sind beispielsweise Amin-, Imin-, Amid- und/oder Hydroxy-Gruppen enthaltende Verbindungen sowie besonders bevorzugt Di- und/oder Polyepoxide.

Gemäß einer Ausführungsform können in der lichtempfindlichen, härtbaren Schicht (S) der erfindungsgemäßen Aufzeichnungsmaterialien solche Verbindungen enthalten sein, in denen die aromatischen und/oder heteroaromatischen o-Nitrocarbinolestergruppierungen der allgemeinen Formel (I) sowie die vernetzend wirkenden, gegenüber Carboxyl-Gruppen reaktiven Gruppen in ein und demselben Molekül gebunden enthalten sind. In diesem Fall handelt es sich bei der Komponente (a) und der Komponente (b) der lichtempfindlichen, härtbaren Schicht (S) um die gleiche Verbindung bzw. die gleichen Verbindungen, d. h. die Komponenten (a) und (b) sind identisch. Zu Verbindungen dieser Art gehören aromatische und/oder heteroaromatische o-Nitrocarbinolestergruppierungen tragende Copolymerisate, die Comonomere mit den vernetzend wirkenden, reaktiven Gruppen, z. B. Amin-, Imin-, Amid-, Hydroxy- und/oder insbesondere Epoxid-Gruppen, einpolymerisiert enthalten. Als Biespiele solcher Comonomeren seien genannt : N,N-Dimethylaminoethyl-(meth)acrylat ; N-Vinylimidazol ; (Meth)-acrylamid, Monoester von Diolen mit ungesättigten Säuren, insbesondere von Acryl- oder Methacrylsäure, wie z. B. Hydroxyethyl-(meth)acrylat, Hydroxypropyl-(meth)acrylat, Butandiol-mono-(meth)acrylat ; Methylolverbindungen vom Amoltyp, z. B. N-Methylolacrylamid, sowie vorzugsweise Glycidylester ungesättigter Säuren, insbesondere der Acryl- oder Methacrylsäure, wie Glycidyl-(meth)acrylat ; Glycidylether ungesättiger Alkohole, wie z. B. Allylglycidylether oder 4-Vinylcyclohexendioxid.

Gemäß einer anderen Ausführungsform können in der lichtempfindlichen, härtbaren Schicht (S) der erfindungsgemäßen Aufzeichnungsmaterialien die vernetzend wirkenden Verbindungen mit den gegenüber Carboxyl-Gruppen reaktiven Gruppen zusätzlich zu den Verbindungen mit den aromatischen und/oder heteroaromatischen o-Nitrocarbinolestergruppierungen enthalten sein, d. h. in diesem Fall handelt es sich bei der Komponente (a) und der Komponente (b) um zwei oder mehrere verschiedene Verbindungen. Hierbei kann die als Komponente (b) eingesetzte vernetzend wirkende Verbindung sowohl eine höhermolekulare Verbindung, wie z. B. ein entsprechendes Polymeres, oder eine niedermolekulare Verbindung sein. Wenn die vernetzend wirkenden Verbindungen (Komponente b) in der lichtempfindlichen, härtbaren Schicht (S) als von der Komponente (a) verschiedene Komponente enthalten sind, sollen sie mit der Komponente (a) verträglich sein. Bevorzugte Klassen von vernetzend wirkenden Verbindungen mit zwei oder mehr der reaktiven Gruppen, die als Zumischkomponente (b) Einsatz finden können, sind u. a. Di- oder Polyhydroxide, Di- oder Polyamine sowie vorzugsweise Di- oder Polyepoxide. Die lichtempfindliche, härtbare Schicht (S) kann dabei auch mehrere der vernetzend wirkenden Verbindungen enthalten.

Bezüglich der als Komponente (b) einzusetzenden, vernetzend wirkenden Verbindungen sei ebenfalls auf die vorerwähnten Druckschriffen, insbesondere die DE-B-23 09 062, die DE-A-32 31 145 sowie DE-A-32 31 147, verwiesen. Als vernetzend wirkende Komponente (b) sind die Di- oder Polyepoxide bevorzugt, welche die Umsetzungsprodukte von Epichlorhydrin mit Polyolen, die Umsetzungsprodukte von Epichlorhydrin mit Polyaminen, Polyolefin-epoxide, epoxidiertes Polybutatien Epoxiharze vom Novolaktyp, Hochpolymere von Glycidylestern ungesättigter Carbonsäuren, insbesondere der (Meth) acrylsäure, und andere umfassen. Von besonderem Interesse sind die Epoxide auf Basis von Epichlorhydrin und Bisphenol A. Durch Substitution des Bisphenol A können die Eigenschaften dieser Epoxide in an sich bekannter Weise beeinflußt werden. Eine andere Gruppe von geeigneten Epoxiden sind diejenigen, in denen die endständigen Glycidylgruppen durch aliphatische oder araliphatische Reste verbunden sind, wofür der Glycidylether des 1,4-Butandiols als typischer Vertreter genannt sein soll. Eine weitere interessante Epoxidverbindung ist das Bis (epoxipropyl) anilin, welches aufgrund seiner äußerst niedrigen Viskosität als bifunktioneller Verdünner eingesetzt werden kann. Unter den hochmolekularen Epoxidverbindungen sind u. a. die Epoxiharze vom Novolaktyp und die Polyglycidyl-(meth)acrylate aufgrund ihrer hohen Funktionalität von Interesse. Durch den Einsatz von cycloaliphatischen Epoxiden, die in ihrem Molekül ein oder mehrere cycloaliphatische Ringe, jedoch keine aromatischen Ringe eingebaut enthalten, kann z. B. die UV-Beständigkeit erhöht werden. Bei den cycloaliphatischen Epoxiden kann der Epoxidsauerstoff ausschließlich an die cycloaliphatischen Ringe gebunden sein, wie z. B. im Dicyclopentadiendioxid, er kann ausschließlich in den Seitenketten gebunden sein, wie z. B. beim Diglycidylester der Hexahydrophthalsäure, oder er kann sowohl an den cyclischen Ringen als auch an die Seitenketten gebunden sein, wie z. B. beim Vinylcyclohexandioxid.

Weitere vernetzend wirkende Verbindungen mit mindestens zwei gegenüber Carboxylgruppen reaktiven Gruppen, die als Komponente (b) in der lichtempfindlichen, härtbaren Schicht (S) enthalten sein können, sind z. B. Phenol-Formaldehyd-Harze, Harnstoff-Formaldehyd-Harze und Melamin-Formaldehyd Harze, wobei die Harze vom Novolak-Typ bevorzugt sind. Die hochmolekularen vernetzend wirkenden Verbindungen mit den gegenüber Carboxylgruppen reaktiven Gruppen werden in der lichtempfindlichen, härtbaren Schicht (S) bevorzugt dann verwendet, wenn die in der lichtempfindlichen, härtbaren Schicht (S) als Komponente (a) enthaltenen Verbindungen mit den o-Nitrocarbinolestergruppierungen ein relativ niedriges Molekulargewicht besitzen, und können dann, wie bereits erwähnt, als polymeres Bindemittel für die lichtempfindliche, härtbare Schicht (S) dienen. Wenn als Komponente (a) o-Nitrocarbinolestergruppierungen tragende Polymere mit hohem Molekulargewicht eingesetzt werden, können die als Komponente (b) zugesetzten vernetzend wirkenden Verbindungen je nach dem

gewünschten Verwendungszweck und angestrebten Eigenschaftsbild der lichtempfindlichen Aufzeichnungsmaterialien niedermolekular oder auch hochmolekular sein.

Das Verhältnis der reaktiven Gruppen in den vernetzend wirkenden Verbindungen der Komponente (b) zu den o-Nitrocarbinolestergruppierungen der allgemeinen Formel (I) in den Verbindungen der Komponente (a) kann in weiten Grenzen variiert werden, so daß der gewünschte Vernetzungs- und Härtungsgrad der lichtempfindlichen, härtbaren Schicht (S) und damit die gewünschten Eigenschaften des lichtempfindlichen Aufzeichnungsmaterials bzw. der daraus hergestellten Reliefbilder oder Resistmuster erreicht werden.

Die erfindungsgemäßen lichtempfindlichen Aufzeichnungsmaterialien enthalten in der lichtempfindlichen, härtbaren Schicht (S) ferner als Komponente (c) mindestens einen in verkappter, nicht aktiver Form vorliegenden Katalysator, der photochemisch und/oder thermisch aktivierbar ist und in seiner aktivierten Form die Reaktion zwischen den Carboxylgruppen und den reaktiven Gruppen der vernetzend wirkenden Verbindung der Komponente (b) beschleunigt. Die photochemisch und/oder thermisch aktivierbaren Katalysatoren, die einzeln oder auch in Mischung miteinander eingesetzt werden können, sind in der lichtempfindlichen, härtbaren Schicht (S) im allgemeinen in einer Menge von 0,05 bis 20 Gewichtsprozent, bezogen auf die lichtempfindliche, härtbare Schicht (S), enthalten. Bezogen auf die vernetzend wirkende Verbindung (Komponente (b)) sind sie in den lichtempfindlichen Aufzeichnungsmaterialien im allgemeinen in Mengen von 0,3 bis 12 Gewichtsprozent enthalten.

Verbindungen, die erfindungsgemäß als Komponente (c) in der lichtempfindlichen, härtbaren Schicht (S) enthalten sein können, sind beispielsweise die für Polymerisation von Epoxiden an sich bekannten und vielfach beschriebenen photochemisch und/oder thermisch zu aktivierenden Katalysatoren bzw. Initiatoren. Hierzu gehören beispielsweise die photochemisch und/oder thermisch aktivierbaren basischen Katalysatoren, wie etwa Bortrifluorid-ethylamin. Günstig sind solche verkappten Katalysatoren, die bei Bestrahlung bzw. Erwärmung Säuren freisetzen. Unter den verkappten, photochemisch und/oder thermisch aktivierbaren Katalysatoren sind die Diazoniumsalze, wie sie in der US-PS 3 205 157 und der US-PS 3 708 296 beschrieben sind, die Oniumsalze von Elementen der V., VI. und VII. Hauptgruppe des Periodensystems (vgl. DE-A 25 18 656, DE-A- 25 18 652, DE-A 29 04 626 und DE-A 25 18 639) sowie die in der EP-A 22 081, der EP-A 35 969 und der EP-A 44 274 genannten Sulfoxoniumsalze, und insbesondere auch die Pyryliumsalze, wie sie in der EP-A 74 073 beschrieben werden, hervorzuheben.

Im allgemeinen handelt es sich bei den erfindungsgemäß einzusetzenden verkappten, photochemisch und/oder thermisch aktivierbaren Katalysatoren um Verbindungen der allgemeinen Formel (II)

$$Y^{\oplus}A^{\ominus} \qquad (II)$$

worin $Y^{\oplus}$ ein geeignetes Kation bedeutet und $A^{\ominus}$ für ein nicht nukleophiles, wenig basisches Anion steht und insbesondere das Tetrafluoroborat-, Hexafluoroarsenat-, Hexafluoroantimonat-, Hexafluorophosphat-, Hexachloroarsenat-, Hexachloroantimonat-, Hydroxypentafluoroantimonat-, Hydroxypentachloroantimonat-, Trifluormethylsulfonat- oder Perchlorat-Anion bedeutet. Als besonders günstig haben sich Verbindungen der allgemeinen Formel (II) mit Hexafluoroarsenat-, Hexafluoroantimonat und Hexafluorophosphat-Anionen erwiesen.

Als Kation $Y^{\oplus}$ für die Verbindungen der allgemeinen Formel (II) kommen z. B. Aryldiazonium-Ionen der allgemeinen Formel (III)

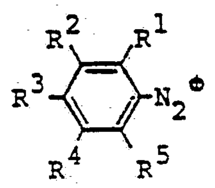

(III)

in Betracht, worin die Reste $R^1$-$R^5$ unabhängig voneinander für Wasserstoffatome, Alkyl-, Cyclohexyl-, Phenyl-, Alkoxy-, Arylthio-, Alkylthio- oder dialkylsubstituierte, diarylsubstituierte oder alkylaryldisubstituierte Amino-Gruppen stehen. Als Beispiel für entsprechende Aryldiazonium-Salze, die z. B. in der US-PS-3 205 157 und insbesondere der US-PS-3 708 296 beschrieben sind, seien insbesondere p-Methoxyphenyl-diazonium-hexafluorophosphat und das 4-(p-Tolylthio)-2,5-diethoxyphenyl-diazonium-hexafluorophosphat genannt.

Eine weitere Gruppe von verkappten Katalysatoren der allgemeinen Formel (II) sind diejenigen mit einem Kation $Y^{\oplus}$ der allgemeinen Formel (IV)

$$[(R^6)_aI]^{\oplus} \qquad (IV)$$

Hierin kann $R^6$ entweder ein monovalenter organischer aromatische Rest, z. B. Phenyl oder durch eine bis drei Alkyl-, Aryl-, Alkoxy-, Aryloxy-, Alkylthiogruppen oder Halogenatome substituiertes Phenyl

sein oder auch ein divalenter aromatischen organischer Rest, wie z. B. 0,0'-Biphenyl, wobei a für den Fall, daß $R^6$ ein monovalenter aromatischer Rest ist, gleich 2 und für den Fall, daß $R^6$ ein bivalenter aromatischer Rest ist, gleich 1 ist. Als Beispiele entsprechender Iodonium-Salze seien genannt: Diphenyliodonium-hexafluorophosphat, Diphenyliodonium-hexafluoroarsenat, Diphenyliodonium-hexafluoroantimonat, Bis-(p-tolyl)iodonium-hexafluorophosphat, Bis(p-tolyl)iodonium-hexafluoroarsenat und Bis(p-tolyl)iodonium-hexafluoroantimonat. Bezüglich der thermisch zu aktivierenden Katalysatoren dieser Klasse sei z. B. auf die DE-A-28 54 011 und die DE-A-29 53 349 verwiesen.

Eine weitere Klasse von geeigneten Katalysatoren stellen die Verbindungen der allgemeinen Formel (II) dar, in denen das Kation $Y^{\oplus}$ der allgemeinen Formel (V)

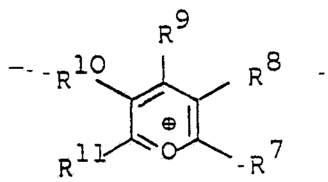

(V)

entspricht, worin die Reste $R^7$ und $R^{11}$ eine Alkyl- oder Alkarylgruppe mit 1 bis 8 C-Atomen und die Reste $R^8$, $R^9$ und $R^{10}$ unabhängig voneinander ein Wasserstoffatom, eine Alkyl-, Alkaryl- oder Cycloalkylgruppe mit bis zu 8 C-Atomen, eine gegebenenfalls alkylsubstituierte Phenyl-, Naphthyl-, Indenyl-, Indanyl- oder Fluorenyl-Gruppe oder einen heterocyclischen Substituenten mit einem oder zwei Heteroatomen bedeuten. Die Reste $R^7$ bis $R^{11}$ stehen dabei isoliert und sind nicht über Ringsysteme miteinander verbunden. Bevorzugt sind $R^7$ und $R^{11}$ Methylgruppen, $R^8$ und $R^{10}$ Wasserstoffatome und $R^9$ ein Phenyl-, Naphthyl- oder Cyclohexyl-Rest. Entsprechende Pyryliumsalze sind beispielsweise in der EP-A-74 073 beschrieben, wobei die Hexafluoroarsenate, Hexafluorophosphate und Tetrafluoroborate mit dem 2,6-Dimethyl-4-phenylpyrylium-Kation, dem 2,6-Dimethyl-4-cyclohexylpyrylium-Kation sowie dem 2,6-Dimethyl-4-napthylpyrylium-Kation besonders hervorzuheben sind.

Ferner sind auch Katalysatoren der allgemeinen Formel (II) günstig, in denen das Kation $Y^{\oplus}$ der allgemeinen Formel (VI)

$$[(R^{12})_b(R^{13})_c(R^{14})_dS]^{\oplus} \qquad (VI)$$

entspricht.

In der Formel (VI) stehen $R^{12}$ für einen monovalenten organischen aromatischen Rest, z. B. einen Phenyl- oder durch eine bis drei Alkyl-, Aryl-, Alkoxy-, Aryloxy-, Alkylthiogruppen oder Halogenatome substituierten Phenylrest, $R^{13}$ für einen bivalenten aromatischen organischen Rest, z. B. 0,0'-Biphenyl-, $R^{14}$ für einen gegebenenfalls substituierten Alkyl- oder Cycloalkyl-Rest, b für eine ganze Zahl von 0 bis 3, c für 0 oder 1 und d für eine ganze Zahl von 0 bis 2 mit der Maßgabe, daß die Summe $b + 2c + d = 3$ ist. Geeignete Verbindungen der allgemeinen Formel (II) mit Kationen der allgemeinen Formel (VI), wie sie beispielsweise in der DE-A-2 518 652, der DE-A-2 839 586, der DE-A-2 904 626, der DE-A-3 104 744 sowie der GB-A-1 526 511 beschrieben sind, sind insbesondere Triphenyl-sulfonium-hexafluorophosphat, Triphenylsulfonium-hexafluoroarsenat, Triphenylsulfonium-hexafluoroantimonat, p-Phenylthiophenyl-diphenylsulfonium-hexafluorophosphat, p-Phenylthiophenyl-diphenylsulfonium-hexafluoroantimonat, p-Phenylthiophenyl-diphenylsulfonium-hexafluoroarsenat.

Weiter sind als geeignete Katalysatoren der allgemeinen Formel (II) solche mit einem Kation der allgemeinen Formel (VII)

$$[(R^{12})_e(R^{13})_g(R^{15})_gZ]^{\oplus} \qquad (VII)$$

zu nennen, worin $R^{12}$ und $R^{13}$ die vorerwähnte Bedeutung haben und $R^{15}$ für einen gegebenenfalls substituierten Alkyl-, Alkoxy-, Aryloxy-, Cycloalkyl- oder Phenacyl-Rest, Z für ein Element der V. Hauptgruppe des Periodensystems der Elemente, wie N, P, As, Sb oder Bi, und e für eine ganze Zahl von 0 bis 4, f für eine ganze Zahl von 0 bis 2 und g für eine ganze Zahl von 0 bis 2 stehen, mit der Maßgabe, daß die Summe $e + 2f + g = 4$ ist. In dieser Klasse von Katalysatoren, die beispielsweise in der DE-A-2 518 562 und der DE-A-3 115 460 angeführt sind, sind insbesondere die Ammoniumsalz-Katalysatoren hervorzuheben, wie sie beispielsweise in der US-PS-4 136 102 beschrieben sind, sowie die Phosphoniumsalz-Katalysatoren, wie sie z. B. in der GB-A-1 516 511, der GB-A-1 554 389 und der US-PS-4 136 102 beschrieben sind, als auch des weiteren Phenacyltriphenylphosphonium-hexafluorophosphat, Phenacyltriphenylphosphonium-hexafluoroarsenat und Phenacyltriphenylphosphonium-hexafluoroantimonat.

Schließlich seien als Katalysatoren auch noch die Sulfoxoniumsalze genannt, d. h. Verbindungen der allgemeinen Formel (II), in denen das Kation der allgemeinen Formel (VIII)

$$[(R^{16})_h(R^{17})_j(R^{18})_kS(O)]^{\oplus} \qquad (VIII)$$

entspricht. In der allgemeinen Formel (VIII) bedeuten $R^{16}$ einen gegebenenfalls substituierten Alkyl-, Aryl-, Cycloalkyl-, Cycloalkylalkyl- oder Arylalkyl-Rest, $R^{17}$ einen gegebenenfalls substituierten Carbamoylmethyl-, Acylmethyl- oder Aroylmethyl-Rest, $R^{18}$ einen Alkoxy- oder Aryloxy-Rest, h eine ganze Zahl von 0 bis 3, j eine ganze Zahl von 0 bis 3 und k eine ganze Zahl von 0 bis 3, mit der Maßgabe, daß die Summe $h + j + k = 3$ ist. Katalysatoren dieses Typs werden beispielsweise in der EP-A-22 081, der EP-A-35 969 sowie der EP-A-44 274 beschrieben.

Für den Einsatz als Komponente (c) in den erfindungsgemäßen lichtempfindlichen Aufzeichnungsmaterialien werden bevorzugt verkappte Katalysatoren aus den Klassen der allgemeinen Formel (II) verwendet, in denen das Kation $Y^+$ einer der allgemeinen Formeln (V) oder (VIII) entspricht.

Allgemein werden die photochemisch aktivierbaren Katalysatoren den thermisch aktivierbaren Katalysatoren wegen der damit erzielbaren höheren Lagerstabilität der so ausgerüsteten lichtempfindlichen Aufzeichnungsmaterialien vorgezogen. Auch wenn die verkappten, photochemisch und/oder thermisch aktivierbaren Katalysatoren als solche grundsätzlich bekannt und beispielsweise für die Härtung von Epoxid-Harzen beschrieben sind, so kommt es erfindungsgemäß darauf an, daß diese Katalysatoren die Vernetzungsreaktion zwischen den bei der Belichtung der lichtempfindlichen Aufzeichnungsmaterialien erzeugten Carboxylgruppen und den vernetzend wirkenden Verbindungen der Komponente (b) bewirken. Nach der photochemischen und/oder thermischen Aktivierung der Katalysatoren ist eine Reaktion zwischen den vernetzend wirkenden Verbindungen der Komponente (b) untereinander nicht auszuschließen. Entscheidend für die Eigenschaften der mit den lichtempfindlichen Aufzeichnungsmaterialien hergestellten Reliefbilder oder Resiststrukturen, insbesondere deren Stabilität, Festigkeit, Reliefstruktur etc., ist jedoch die Vernetzungsreaktion zwischen den Carboxylgruppen und den reaktiven Gruppen der vernetzend wirkenden Komponente (b). Daß bei Einsatz der genannten Katalysatoren diese Reaktion in dem erforderlichen Maße abläuft und Produkte mit den verbesserten, vorteilhaften Eigenschaften erhalten werden können, war überraschend und in keiner Weise zu erwarten.

Die lichtempfindliche härtbare Schicht (S) der erfindungsgemäßen Aufzeichnungsmaterialien kann darüber hinaus weitere übliche und an sich bekannte Zusatz- und/oder Hilfsstoffe enthalten. Hierbei kann es sich einerseits um Verbindungen handeln, die die Herstellung der lichtempfindlichen härtbaren Schicht (S) erleichtern, wie z. B. Weichmacher oder Verlaufsmittel, oder auch um solche Zusatzstoffe, die die anwendungstechnischen Eigenschaften dieser Schicht verbessern oder modifizieren.

Beispiele für weichmachende Verbindungen, die insbesondere dann zugesetzt werden, wenn die lichtempfindliche härtbare Schicht (S) durch Laminieren auf den dimensionsstabilen Träger aufgebracht werden soll und die mit den die o-Nitrocarbinolestergruppierungen der allgemeinen Formel (I) enthaltenden Verbindungen verträglich sein sollen, sind Trikresylphosphat, n-Butyl-benzyl-phthalat und flüssige Polyester aus aliphatischen Dicarbonsäuren und bifunktionellen Glykolen, insbesondere Polyester aus Adipinsäure und 1,2-Propylenglykol oder 1,4-Butandiol mit einer Viskosität von 1 000 bis 15 000 cP. Sind in der lichtempfindlichen härtbaren Schicht (S) als Komponente (b) niedermolekulare vernetzend wirkende Verbindungen als Zumischkomponente enthalten, so können diese auch als Weichmacher wirken und den Zusatz von gesonderten weichmachenden Verbindungen teilweise oder vollständig überflüssig machen. Verlaufsmittel, wie z. B. Silikonöle, sind insbesondere dann empfehlenswert, wenn die lichtempfindliche härtbare Schicht (S) durch Gießen aus Lösung auf den Träger aufgebracht werden soll.

Weiterhin kommen als Zusatzstoffe beispielsweise Sensibilisatoren, die die Lichtempfindlichkeit und die spektrale Empfindlichkeit der Schicht (S) verbessern, Farbstoffe, Pigmente und/oder photochrome Substanzen sowie auch feinteilige Füllstoffe in Betracht. Beispiele für Sensibilisatoren sind Xanthen-Farbstoffe, wie Fluoreszein, Eosin und Rhodamin sowie Triplet-Energieüberträger, wie sie beispielsweise N.J. Turro in seinem Buch « Molecular Photochemistry », W.A. Benjamin Inc., New York, 1967 auf Seite 132 beschreibt. Als Farbstoffe haben sich u.a. Sudanfarbstoffe, Polymethinfarbstoffe, Azofarbstoffe, Phthalocyanin-Farbstoffe oder Dispersionsfarbstoffe sowie Eosin, Kristallviolett oder Malachitgrün bewährt. Besonders vorteilhaft sind solche Farbstoffe, die bei der Belichtung mit aktinischem Licht ihre Färbung reversibel oder irreversibel ändern. Wenn die erfindungsgemäßen lichtempfindlichen Aufzeichnungsmaterialien für die Herstellung von polymeren Tiefdruckformen eingesetzt werden sollen, können in der lichtempfindlichen härtbaren Schicht (S) insbesondere feinteilige abrasive Füllstoffe enthalten sein, wie es in der EP-A 70 511 beschrieben ist. Durch Zusatz dieser Füllstoffe kann nicht nur die Härte der Schicht (S) erhöht werden, sondern es können darüber hinaus auch z. B. die Fließeigenschaften, Steifigkeit etc. der Schicht (S) verbessert werden. Bei den feinteiligen Füllstoffen, deren mittlere Teilchengröße vorzugsweise im Bereich von 0,01 bis 6 µm liegt und deren Härte im allgemeinen größer 4,0, insbesondere größer 6 auf der Mohsschen Härteskala betragen soll, handelt es sich insbesondere um mineralische Füllstoffe und Pigmente, wie z. B. Siliciumdioxid, Silikate, Aluminiumoxide, Titanoxid, Siliciumkarbid, Wolframkarbid u. a.

Die lichtempfindliche härtbare Schicht (S) der erfindungsgemäßen Aufzeichnungsmaterialien ist im allgemeinen fest, trocken und nicht klebrig. Sie kann auf der dem Träger abgewandten Seite auch noch mit einer Schutz- oder Deckfolie versehen sein, beispielsweise aus einem Polyester, Polyolefin, Polyvinylalkohol oder dergleichen. Wie bereits erwähnt, können die erfindungsgemäßen lichtempfindlichen Aufzeichnungsmaterialien nach den bekannten Techniken hergestellt werden, beispielsweise durch Gießen der lichtempfindlichen härtbaren Schicht (S) aus Lösung auf den dimensionsstabilen Träger. Man kann die lichtempfindliche härtbare Schicht (S) jedoch auch beispielsweise durch Pressen oder Kalandrieren formen und anschließend auf den Träger unter Anwendung von Druck und/oder Wärme auflaminieren. Die Schichtdicke der lichtempfindlichen härtbaren Schicht (S) hängt von dem jeweiligen Verwendungszweck der Aufzeichnungsmaterialien ab und kann daher in weiten Grenzen variiert werden. Da sich die erfindungsgemäßen Aufzeichnungsmaterialien sowohl für die Herstellung von Offset-Druckplatten und Resisten einerseits, aber auch für die Herstellung von Hochdruck-, Tiefdruck- oder Reliefformen andererseits eignen, kann die Schichtdicke der lichtempfindlichen härtbaren Schicht (S) beispielsweise im Bereich von 0,01 μm bis zu einigen Millimetern, z. B. 3 bis 4 mm, liegen.

Die erfindungsgemäßen lichtempfindlichen Aufzeichnungsmaterialien können beispielsweise für die Herstellung von Hoch-, Tief-, Offset- oder Siebdruckformen, Resisten oder Lötstoppmasken verwendet werden. Sie eignen sich auch für Schichtübertragungsmaterialien bei der Herstellung von Leiterplatten, gedruckten Schaltungen, integrierten Schaltungen etc. Die Herstellung der Reliefbilder oder Resistmuster mittels der erfindungsgemäßen Aufzeichnungsmaterialien kann wahlweise nach negativ arbeitenden oder positiv arbeitenden Verfahren erfolgen, wie sie an sich bekannt und beispielsweise in der DE-B 2 309 062 sowie den älteren Patentanmeldungen EP-A-101 587, EP-A-101 976 und EP-A-101 586 beschrieben sind. Hierzu wird zunächst in allen Fällen die lichtempfindliche härtbare Schicht (S) der erfindungsgemäßen Aufzeichnungsmaterialien bildmäßig mit aktinischem Licht belichtet. Geeignete Lichtquellen hierfür sind solche, die aktinisches Licht im Wellenlängenbereich von 200 bis 600 nm, vorzugsweise im Wellenlängenbereich von 300 bis 420 nm, ausstrahlen, wie z. B. Kohlebogenlampen, Quecksilberhochdrucklampen, Xenonhochdrucklampen und insbesondere Quecksilberniederdruckfluoreszenzlampen. Die bildmäßige Belichtung erfolgt dabei je nach Verfahrensführung entweder durch ein Bildpositiv oder Bildnegativ oder bei der Herstellung von Tiefdruckformen auch durch ein Raster- oder Strich-Positiv bzw. ein Raster- oder Strich-Negativ, wobei letzteres auch zusammen mit einem Halbton-Negativ angewandt werden kann. Die bildmäßige Belichtung der lichtempfindlichen härtbaren Schicht (S) kann auch mit einem bildmäßig modulierten, aktinischen Laserstrahl, z. B. einem UV-Laser, erfolgen. Die Belichtungszeiten für die bildmäßige Belichtung liegen im allgemeinen im Bereich von 0,01 bis 90 Minuten.

Bei den positiv arbeitenden Verfahren zur Herstellung der Reliefbilder oder Resistmuster werden nach der bildmäßigen Belichtung der lichtempfindlichen härtbaren Schicht (S) die belichteten Schichtanteile, in denen die o-Nitrocarbinolestergruppierungen unter Bildung von freien Carboxylgruppen gespalten worden sind, mit einem wäßrigen Entwicklerlösungsmittel in üblicher Weise, beispielsweise durch Besprühen, Ausreiben oder Ausbürsten, entfernt. Der Vorgang der bildmäßigen Belichtung und des Auswaschens der lichtempfindlichen Schicht (S) kann bei den positiv arbeitenden Verfahren gewünschtenfalls mehrmals wiederholt werden. Nach der letzten bildmäßigen Belichtung sowie dem Entfernen der belichteten Schichtanteile wird der auf dem Träger verbliebene Teil der lichtempfindlichen Schicht (S), der nunmehr bereits ein positives Abbild der bildmäßigen Vorlage darstellt, vollflächig mit aktinischem Licht nachbelichtet. Für diese vollflächige Nachbelichtung können die gleichen Lichtquellen herangezogen werden, wie für die vorerwähnte bildmäßige Belichtung, wobei die Dauer für die vollflächige Nachbelichtung im allgemeinen ebenfalls im Bereich von 0,01 bis 90 Minuten liegt. Im Anschluß an die vollflächige Nachbelichtung wird die Schicht (S) thermisch vernetzt und gehärtet.

In den negativ arbeitenden Verfahren werden nach der bildmäßigen Belichtung der Schicht (S) die belichteten Bereiche zunächst selektiv thermisch gehärtet und vernetzt. Die nichtvernetzten Bereiche der Schicht (S) können danach direkt mit einem geeigneten Entwicklerlösungsmittel ausgewaschen werden. Vorteilhafterweise wird jedoch die Schicht (S) zunächst noch einmal vollflächig mit aktinischem Licht nachbelichtet und dann mit einem wäßrigen Entwicklerlösungsmittel ausgewaschen. Nach dem Auswaschen der Schicht (S) kann diese noch einmal thermisch nachgehärtet und nachvernetzt werden. Erfolgt das Auswaschen der Schicht (S) unmittelbar nach der bildmäßigen Belichtung, so ist für eine solche thermische Nachvernetzung und Nachhärtung die Schicht (S) nach dem Auswaschen noch einmal vollflächig mit aktinischem Licht zu belichten.

Als Entwickler-Lösungsmittel können in den negativ arbeitenden Verfahren geeignete organische Lösungsmittel eingesetzt werden ; vorzugsweise werden sowohl in den positiv arbeitenden als auch den negativ arbeitenden Verfahren wäßrige Entwickler-Lösungsmittel eingesetzt. Hierbei kann es sich um Wasser oder auch um Mischungen von Wasser mit wasserlöslichen organischen Lösungsmitteln handeln, denen gegebenenfalls zur Einstellung eines optimalen pH-Wertes geringe Mengen an Alkalien oder organischen Basen zugesetzt werden können.

Die Bedingungen für die thermische Härtung und Vernetzung der Schicht (S) hängt u. a. von dem als Komponente (C) eingesetzten verkappten Katalysator ab. Sind in der Schicht (S) photoaktivierbare Katalysatoren enthalten, so werden diese bei der vorerwähnten Belichtung der Schicht (S) mit aktinischem Licht in den aktivierten Zustand versetzt. Die Härtung und Vernetzung der Schicht (S) kann daher in diesen Fällen bereits bei Raumtemperatur erfolgen, jedoch sind dann im allgemeinen sehr lange Härtungszeiten notwendig. Vorteilhafterweise wird daher die Härtung und Vernetzung bei erhöhten Temperaturen durchgeführt. Sind in der Schicht (S) thermisch aktivierbare Katalysatoren enthalten, so erfolgt die Härtung und Vernetzung der Schicht (S) nach der bildmäßigen oder vollflächigen Belichtung

der Schicht (S) bei Temperaturen, die über der Aktivierungstemperatur für den Katalysator liegen. Es ist ein besonderer Vorteil der erfindungsgemäßen Aufzeichnungsmaterialien, daß die Temperaturen für die thermische Härtung und Vernetzung der Schicht (S) vergleichsweise niedrig gehalten werden können, ohne daß die Lagerstabilität der Aufzeichnungsmaterialien beeinträchtigt wird. Im allgemeinen können mit den erfindungsgemäßen Aufzeichnungsmaterialien die Temperaturen für die thermische Härtung und Vernetzung der Schicht (S) unter 150 °C gehalten werden, so daß auch thermisch empfindliche Untergründe, wie sie z. B. in der Dünnschichttechnologie und bei der Herstellung von Leiterbahnen zur Anwendung kommen können, als Trägermaterialien eingesetzt werden können. Im allgemeinen liegen die Temperaturen für die thermische Härtung und Vernetzung der Schicht (S) im Bereich von 30 bis 150 °C, vorzugsweise im Bereich von 50 bis 130 °C. Die Dauer für die thermische Härtung und Vernetzung der Schicht (S) liegt üblicherweise im Bereich von 10 Minuten bis einigen Stunden, beispielsweise 5 Stunden. Grundsätzlich werden die Bedingungen für die thermische Härtung und Vernetzung der Schicht (S) so gewählt, daß die gehärteten und vernetzten Reliefbilder oder Resistmuster die gewünschten mechanischen, physikalischen und chemischen Eigenschaften besitzen.

Die erfindungsgemäßen Aufzeichnungsmaterialien sind sehr lagerstabil. Sie können beispielsweise mehrere Wochen bei 50 °C gelagert werden, ohne daß sich dadurch die sehr guten Eigenschaften der Aufzeichnungsmaterialien und die hohe Qualität der hieraus hergestellten Reliefbilder oder Resistmuster verschlechtert.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

72 Teile eines Methylmethacrylats-Copolymerisats, welches 35 % o-Nitrobenzylacrylat enthielt, 27 Teile eines Bisphenol-A-Diglycidylether (Epicote[R] 828 der Firma Shell), 0,7 Teile Benzildimethylketal, 0,1 Teile eines schwarzen Farbstoffes, 0,2 Teiles des Polymethinfarbstoffes der Formel

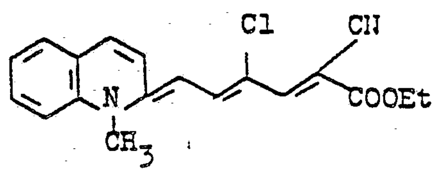

sowie ein Teil Bortrifluorid-ethylamin als verkappter, thermisch aktivierbarer basischer Katalysator wurden in 160 Vol.-Teilen Essigsäureethylester gelöst. Aus dieser Lösung wurde auf eine Polyesterfolie eine lichtempfindliche härtbare Schicht (S) so gegossen, daß nach Entfernung des Lösungsmittels und Trocknung eine Schichtdicke von etwa 10 µm resultierte. Das so hergestellte Aufzeichnungsmaterial wurde über 6 Wochen bei 50 °C gelagert. Danach wurde zur Herstellung von Resistmustern die freie Oberfläche der Schicht (S) 90 sec vollflächig mit einer 500 Watt Höchstdruck-Quecksilberlampe vorbelichtet und auf ein Palladium bedampftes Glas auflaminiert. Die lichtempfindliche Schicht (S) wurde dann mittels einer photografischen Positiv-Vorlage durch die Polyesterfolie hindurch mit einer 500 W Höchstdruck-Quecksilberlampe 3 Minuten lang bildmäßig belichtet. Anschließend wurde die Polyesterfolie von der Schicht (S) abgezogen und die belichteten Anteile der Schicht (S) mit einem wäßrigen Entwicklerlösungsmittel (81 Teile Wasser, 16 Teile 2-Butoxyethanol, 3 Teile Triethanolamin), in 1,5 Minuten ausgewaschen. Das so erhaltene vorlagengetreue Resistmuster wurde mit der gleichen Lampe wie oben nochmals vollflächig, d. h. ohne bildmäßige Vorlage, für eine Dauer von 15 Minuten nachbelichtet und dann insgesamt 120 Minuten in steigenden Temperaturschritten von je 20 °C im Temperaturbereich von 60 °C bis 140 °C thermisch gehärtet und vernetzt. Der erhaltene Resist war hervorragend als Ätzresist geeignet und gegen die konzentrierte Salpetersäure (65 %ig) des Palladiumätzbades stabil. Nach dem Ätzen und Strippen des Resistes mit heißem Dimethylformamid wurden so Palladiumbahnen erhalten, die eine getreue Wiedergabe der Bildvorlage darstellten.

Vergleichsversuch A

Es wurde wie in Beispiel 1 verfahren, diesmal jedoch auf dem Zusatz des Bortrifluorid-ethylamin-Katalysators verzichtet. Zur Erzielung einer hinreichenden Stabilität gegenüber dem Palladiumätzbad mußte das Resistmuster nach der vollflächigen Nachbelichtung bei steigender Temperatur je 30 Minuten bei 60 °C, 80 °C, 100 °C, 120 °C und 160 °C sowie 120 Minuten bei 200 °C gehärtet und vernetzt werden. Die Flanken der Resistbahnen waren schräg und hatten im Querschnitt die Form eines Tropfens. Der Masseverlust war durch abnehmende Schichtdicke des Resists zu erkennen.

Vergleichsversuch B

Es wurde wie in Beispiel 1 verfahren, jedoch wurde anstelle des Bortrifluorid-ethylamin-Katalysators diesmal ein Teil Benzyldimethylamin als Härtungskatalysator eingesetzt. Die Lagerstabilität des so hergestellten Aufzeichnungsmaterials war erheblich geringer, selbst bei zügiger Verarbeitung der belichteten Schicht (S) war eine einwandfreie Entwicklung des Resistmusters nicht möglich. Auch mit gleichen Mengen anderer basischer Katalysatoren, wie Diazabicyclooctan und Benzyltrimethylammoniumhydroxid, wurde keine ausreichende Lagerstabilität erreicht.

Beispiel 2

Es wurde wie in Beispiel 1 gearbeitet, diesmal jedoch anstelle des Bortrifluorid-ethylamin-Katalysators 4 Teile 2,6-Dimethyl-4-phenylpyrylium-hexafluorophosphat als verkappter sauer Katalysator in die Schicht (S) eingearbeitet. Die Zeiten für die bildmäßige Belichtung lagen bei 2 Minuten, und die für die vollflächige Nachbelichtung bei 15 Minuten. Bereits bei einer thermischen Härtung der belichteten und entwickelten Resistschicht von insgesamt 120 Minuten bei steigenden Temperaturen im Temperaturbereich von 60 bis 120 °C wurde ein gegen konzentrierte Salpetersäure stabiler Resist erhalten. Die Flanken des Resistmusters waren steil ausgeprägt.

Beispiel 3

Es wurde wie in Beispiel 2 verfahren, jedoch anstelle des Hexafluorophosphats das Tetrafluoroborat des 2,6-Dimethyl-4-phenylpyryliums eingesetzt. Es wurden entsprechende Ergebnisse wie in Beispiel 2 erzielt.

Beispiel 4

Es wurde wie in Beispiel 1 gearbeitet, jedoch anstelle des Bortrifluorid-ethylamin-Katalysators diesmal 4 Teile Diphenyliodoniumhexafluorophosphat als Katalysator in die Schicht (S) eingearbeitet. Das so hergestellte Aufzeichnungsmaterial zeigte nach 6 Wochen Lagerung bei 50 °C keinerlei Veränderungen der Eigenschaften. Die thermische Härtung und Nachvernetzung lieferte bereits bei Temperaturen bis 120 °C (Dauer 120 Minuten) ein sehr beständiges und stabiles Resistmuster, welches sauber ausgebildete, scharfkantige Flanken aufwies.

**Patentansprüche**

1. Für die Herstellung von Reliefbildern oder Resistmustern geeignetes lichtempfindliches Aufzeichnungsmaterial mit einer auf einem dimensionsstabilen Träger aufgebrachten lichtempfindlichen härtbaren Schicht (S), die enthält

a) eine Verbindung mit mindestens zwei aromatischen und/oder heteroaromatischen o-Nitrocarbinolestergruppierungen der allgemeinen Formel (I)

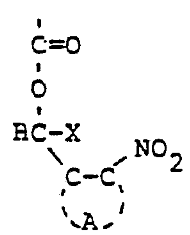

(I)

worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 Kohlenstoffatomen oder einen gegebenenfalls substituierten Aryl- oder Aralkylrest bedeuten,

b) eine vernetzend wirkende Verbindung mit mindestens zwei reaktiven Gruppen, die unter dem

Einfluß von Wärme mit —COOH-Gruppen unter Bildung einer kovalenten chemischen Bindung zu reagieren vermögen,

c) mindestens einen Katalysator, der die Reaktion zwischen den vernetzend wirkenden Verbindungen (b) und den —COOH-Gruppen zu beschleunigen vermag,

sowie gegebenenfalls

d) übliche Zusatz- und/oder Hilfsstoffe,

dadurch gekennzeichnet, daß als Komponente (c) mindestens ein in verkappter, nicht aktiver Form vorliegender Katalysator enthalten ist, der photochemisch mit aktinischem Licht und/oder thermisch aktivierbar ist.

2. Lichtempfindliches Aufzeichnungsmaterial nach Anspruch 1, dadurch gekennzeichnet, daß der verkappte, photochemisch und/oder thermisch aktivierbare Katalysator (c) der allgemeinen Formel (II)

$$Y^{\oplus}A^{\ominus} \qquad (II)$$

entspricht, worin $A^{\ominus}$ das Tetrafluoroborat-, Hexafluorophosphat-, Hexafluoroantimonat-, Hexafluoroarsenat-, Hexachloroarsenat-, Hexachloroantimonat-, Hydroxypentafluoroantimonat- oder Hydroxypentachloroantimonat-Anion bedeutet und $Y^{\oplus}$ für ein geeignetes Gegenkation steht.

3. Lichtempfindliches Aufzeichnungsmaterial gemäß Anspruch 2, dadurch gekennzeichnet, daß in der lichtempfindlichen härtbaren Schicht (S) als Komponente (c) ein verkappter, photochemisch und/oder thermisch aktivierbarer Katalysator der allgemeinen Formel (II) enthalten ist, in der $Y^{\oplus}$ ein Aryldiazoniumion der allgemeinen Formel (III)

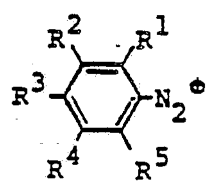
(III)

darstellt, worin die Reste $R^1$ bis $R^5$ unabhängig voneinander ein Wasserstoffatom, einen Alkyl-, Cyclohexyl-, Phenyl-, Alkoxy-, Arylthio-, Alkylthio- oder einen disubstituierten Amino-Rest bedeuten.

4. Lichtempfindliches Aufzeichnungsmaterial gemäß Anspruch 2, dadurch gekennzeichnet, daß in der lichtempfindlichen härtbaren Schicht (S) als Komponente (c) ein verkappter photochemisch und/oder thermisch aktivierbarer Katalysator der allgemeinen Formel (II) enthalten ist, worin $Y^{\oplus}$ ein Iodoniumion der allgemeinen Formel (IV)

$$[(R^6)_aI]^{\oplus} \qquad (IV)$$

bedeutet, in der $R^6$ für einen monovalenten oder bivalenten organischen aromatischen Rest steht und a für den Fall, daß $R^6$ ein monovalenter aromatischer Rest ist, gleich 2 ist und für den Fall, daß $R^6$ ein bivalenter aromatischer Rest ist, gleich 1 ist.

5. Lichtempfindliches Aufzeichnungsmaterial nach Anspruch 2, dadurch gekennzeichnet, daß in dem Katalysator (c) der allgemeinen Formel (II) $Y^{\oplus}$ ein Pyryliumion der allgemeinen Formel (V)

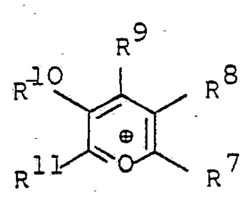
(V)

darstellt, worin die Reste $R^7$ und $R^{11}$ eine Alkyl- oder Alkarylgruppe mit 1 bis 8 Kohlenstoffatomen, $R^8$, $R^9$ und $R^{10}$ unabhängig voneinander ein Wasserstoffatom, einen Alkyl-, Alkaryl- oder Cycloalkylrest mit bis zu 8 Kohlenstoffatomen, eine gegebenenfalls alkylsubstituierte Phenyl-, Naphthyl-, Indenyl-, Indanyl- oder Fluorenyl-Gruppe oder einen heterocyclischen Substituenten mit einem oder zwei Heteroatomen bedeuten.

6. Lichtempfindliches Aufzeichnungsmaterial gemäß Anspruch 2, dadurch gekennzeichnet, daß in dem Katalysator der allgemeinen Formel (II) $Y^{\oplus}$ ein Kation der allgemeinen Formel (VI)

$$[(R^{12})_b(R^{13})_c(R^{14})_dS]^{\oplus} \qquad (VI)$$

bedeutet, worin $R^{12}$ für einen monovalenten organischen aromatischen Rest, $R^{13}$ für einen bivalenten organischen aromatischen Rest und $R^{14}$ für einen Alkyl-, substituierten Alkyl- oder Cycloalkylrest

stehen und b eine ganze Zahl von 0 bis 3, c 0 oder 1 und d eine ganze Zahl von 0 bis 2 ist, mit der Maßgabe, daß die Summe b + 2 c + d = 3 ist.

7. Lichtempfindliches Aufzeichnungsmaterial gemäß Anspruch 2, dadurch gekennzeichnet, daß in dem Katalysator (c) der allgemeinen Formel (II) $Y^{\oplus}$ ein Kation der allgemeinen Formel (VII)

$$[(R^{12})_e(R^{13})_f(R^{15})_gZ]^{\oplus} \qquad (VII)$$

ist, worin $R^{12}$ einen monovalenten organischen aromatischen Rest, $R^{13}$ einen bivalenten organischen aromatischen Rest, $R^{15}$ einen gegebenenfalls substituierten Alkyl-, Alkoxy-, Aryloxy-, Cycloalkyl- oder Phenacyl-Rest und Z ein Element der V. Hauptgruppe des Periodensystems darstellt und worin e eine ganze Zahl von 0 bis 4, f eine ganze Zahl von 0 bis 2 und g eine ganze Zahl von 0 bis 2 darstellt mit der Maßgabe, daß die Summe e + 2 f + g = 4 ist.

8. Lichtempfindliches Aufzeichnungsmaterial gemäß Anspruch 2, dadurch gekennzeichnet, daß in dem Katalysator (c) der allgemeinen Formel (II) $Y^{\oplus}$ ein Kation der allgemeinen Formel (VIII)

$$[(R^{16})_h(R^{17})_j(R^{18})_kS(O)]^{\oplus} \qquad (VIII)$$

ist, worin $R^{16}$ ein gegebenenfalls substituierter Alkyl-, Aryl-, Cycloalkyl-, Cycloalkylalkyl- oder Arylalkyl-Rest, $R^{17}$ ein gegebenenfalls substituierter Carbamoylmethyl-, Acylmethyl- oder Aroylmethyl-Rest und $R^{18}$ ein Alkoxy- oder Aryloxy-Rest ist und h eine ganze Zahl von 0 bis 3, j eine ganze Zahl von 0 bis 3 sowie k eine ganze Zahl von 0 bis 3 ist mit der Maßgabe, daß die Summe h + j + k = 3 ist.

9. Lichtempfindliches Aufzeichnungsmaterial nach einem der Ansprüche 1 bis 8, dadurch gekennzeichnet, daß die lichtempfindliche härtbare Schicht (S) den oder die verkappten, photochemisch und/oder thermisch aktivierbaren Katalysatoren (c) in einer Menge von 0,05 bis 20 gew.-%, bezogen auf die lichtempfindliche härtbare Schicht (S), enthält.

10. Lichtempfindliches Aufzeichnungsmaterial nach einem der Ansprüche 1 bis 9, dadurch gekennzeichnet, daß die lichtempfindliche härtbare Schicht (S) eine Verbindung, insbesondere ein Polymeres, enthält, welches neben den o-Nitrocarbinolestergruppierungen der allgemeinen Formel (I) gleichzeitig die vernetzend wirkenden, gegenüber —COOH-Gruppen reaktiven Gruppen im Molekül eingebaut enthält.

11. Lichtempfindliches Aufzeichnungsmaterial gemäß Anspruch 10, dadurch gekennzeichnet, daß die o-Nitrocarbinolestergruppierungen der Formel (I) enthaltende Verbindung zusätzlich Amin-, Imin-, Amid-, Epoxid- oder Hydroxy-Gruppen eingebaut enthält.

12. Lichtempfindliches Aufzeichnungsmaterial gemäß einem der Ansprüche 1 bis 9, dadurch gekennzeichnet, daß die lichtempfindliche härtbare Schicht (S) neben der Verbindung mit den o-Nitrocarbinolestergruppierungen der Formel (I) zusätzlich eine oder mehrere vernetzend wirkende Verbindungen mit mindestens zwei reaktiven Gruppen der genannten Art enthält.

13. Lichtempfindliches Aufzeichnungsmaterial gemäß Anspruch 12, dadurch gekennzeichnet, daß die lichtempfindliche härtbare Schicht (S) als vernetzend wirkende Verbindung Epoxide, Alkohole und/oder Amine enthält.

## Claims

1. A photosensitive recording material which is suitable for the production of relief or resist images and possesses a curable, photosensitive layer (S) which is applied to a dimensionally stable base and which contains

a) a compound possessing two or more aromatic and/or heteroaromatic o-nitrocarbinol ester groups of the general formula (I)

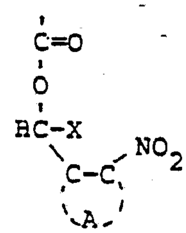

(I)

where A is a radical of an unsubstituted or substituted, 5-membered to 14-membered aromatic or heteroaromatic ring system, and X is hydrogen, alkyl of 1 to 8 carbon atoms or an unsubstituted or substituted aryl or aralkyl radical,

b) a compound which effects crosslinking and possesses two or more reactive groups which are capable of reacting with —COOH groups under the action of heat to form a covalent chemical bond, and

c) one or more catalysts for the reaction of the compound (b), which effects crosslinking, with COOH-containing compounds, with or without

d) conventional additives and/or assistants,

wherein there is contained, as component (c), at least one catalyst which is present in a blocked non-active form and can be activated photochemically with actinic light and/or thermally.

2. A photosensitive recording material as claimed in claim 1, wherein the blocked catalyst (c) which can be activated photochemically and/or thermally is of the general formula (II)

$$Y^{\oplus}A^{\ominus} \qquad \text{(II)}$$

where $A^{\ominus}$ is a tetrafluoroborate, hexafluorophosphate, hexafluoroantimonate, hexafluoroarsenate, hexachloroarsenate, hexachloroantimonate, hydroxypentafluoroantimonate or hydroxypentachloroantimonate anion and $Y^{\oplus}$ is a suitable counter-cation.

3. A photosensitive recording material as claimed in claim 2, wherein the curable photosensitive layer (S) contains, as component (c), a blocked catalyst which can be activated photochemically and/or thermally and which is of the general formula (II), in which $Y^{\oplus}$ is an aryl-diazonium ion of the general formula (III)

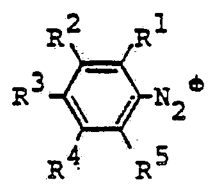

(II)

where $R^1$, $R^2$, $R^3$, $R^4$ and $R^5$ independently of one another are hydrogen, alkyl, cyclohexyl, phenyl, alkoxy, arylthio or alkylthio or a disubstituted amino radical.

4. A photosensitive recording material as claimed in claim 2, wherein the curable photosensitive layer (S) contains, as component (c), a blocked catalyst which can be activated photochemically and/or thermally and which is of the general formula (II), in which $Y^{\oplus}$ is an iodonium ion of the general formula (IV)

$$[(R^6)_aI]^{\oplus} \qquad \text{(IV)},$$

where $R^6$ is a monovalent or bivalent organic aromatic radical and a is 2 where $R^6$ is a monovalent aromatic radical, and is 1 where $R^6$ is a bivalent aromatic radical.

5. A photosensitive recording material as claimed in claim 2, wherein, in the catalyst (c) of the general formula (II), $Y^{\oplus}$ is a pyrylium ion of the formula (V)

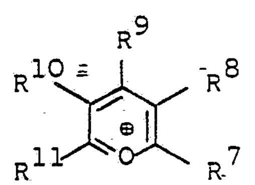

(V)

where $R^7$ and $R^{11}$ are each an alkyl or alkaryl group of 1 to 8 carbon atoms, and $R^8$, $R^9$ and $R^{10}$ independently of one another are hydrogen, an alkyl, alkaryl or cycloalkyl radical of up to 8 carbon atoms, an unsubstituted or alkyl-substituted phenyl, naphthyl, idenyl, indanyl or fluorenyl group or heterocyclic substituent possessing one or two heteroatoms.

6. A photosensitive recording material as claimed in claim 2, wherein, in the catalyst of the general formula (II), $Y^{\oplus}$ is a cation of the formula (VI)

$$[(R^{12})_b(R^{13})_c(R^{14})_dS]^{\oplus} \qquad \text{(VI)}$$

where $R^{12}$ is a monovalent organic aromatic radical, $R^{13}$ is a bivalent organic aromatic radical, $R^{14}$ is unsubstituted or substituted alkyl or is cycloalkyl, b is an integer from 0 to 3, c is 0 or 1 and d is an integer from 0 to 2, with the proviso that the sum of b + 2 c + d is 3.

7. A photosensitive recording material as claimed in claim 2, wherein, in the catalyst (c) of the general formula (II), $Y^{\oplus}$ is a cation of the general formula (VII)

$$[(R^{12})_e(R^{13})_f(R^{15})_gZ]^{\oplus} \qquad \text{(VII)}$$

where $R^{12}$ is a monovalent organic aromatic radical, $R^{13}$ is a bivalent organic aromatic radical, $R^{15}$ is an unsubstituted or substituted alkyl, alkoxy, aryloxy, cycloalkyl or phenacyl radical, Z is an element of main group V of the periodic table, e is an integer from 0 to 4 and, f and g are each an integer from 0 to 2, with the proviso that the sum of e + 2 f + g is 4.

8. A photosensitive recording material as claimed in claim 2, wherein, in the catalyst (c) of the general formula (II), $Y^{\oplus}$ is a cation of the general formula (VIII).

$$[(R^{16})_h(R^{17})_j(R^{18})_kS(O)]^{\oplus} \qquad (VIII)$$

where $R^{16}$ is an unsubstituted or substituted alkyl, aryl, cycloalkyl, cycloalkylalkyl or arylalkyl radical, $R^{17}$ is an unsubstituted or substituted carbamylmethyl, acylmethyl or aroylmethyl radical, $R^{18}$ is alkoxy or aryloxy, and h, j and k are each an integer from 0 to 3, with the proviso that the sum of h + j + k is 3.

9. A photosensitive recording material as claimed in any of claims 1 to 8, wherein the curable photosensitive layer (S) contains from 0.05 to 20 % by weight, based on the curable photosensitive layer (S), of the blocked catalyst or catalysts (c) which can be activated photochemically and/or thermally.

10. A photosensitive recording material as claimed in any of claims 1 to 9, wherein the curable photosensitive layer (S) contains a compound, in particular a polymer, whose molecule, in addition to containing the o-nitrocarbinol ester groups of the general formula (I), also contains the groups which effect crosslinking and are reactive toward —COOH groups.

11. A photosensitive recording material as claimed in claim 10, wherein the compound which contains o-nitrocarbinol ester groups of the formula (I) additionally contains amine, imine, amide, epoxide or hydroxyl groups.

12. A photosensitive recording material as claimed in any of claims 1 to 9, wherein the curable photosensitive layer (S), in addition to containing the compound which possesses the o-nitrocarbinol ester groups of the formula (I), also contains one or more compounds which effect crosslinking and possess two or more reactive groups of the said type.

13. A photosensitive recording material as claimed in claim 12, wherein the curable photosensitive layer (S) contains, as compounds which effect crosslinking, epoxides, alcohols and/or amines.

**Revendications**

1. Matériau d'enregistrement photosensible, convenant pour la production d'images en relief ou de motifs de réserve, comportant une couche photosensible durcissable (S), appliquée sur un support dimensionnellement stable et contenant

a) un composé comportant au moins deux groupements ester d'ortho-nitro-carbinol aromatiques et(ou) hétéro-aromatiques de la formule générale (I)

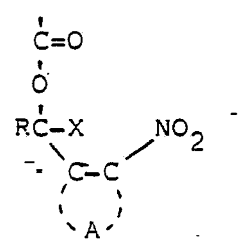

. (I)

dans laquelle A représente le reste d'un système cyclique aromatique ou hétéro-aromatique, éventuellement substitué, avec cinq à quatorze chaînons et X désigne un atome d'hydrogène ou un radical alkyle en $C_1$ à $C_8$ ou un groupe aryle ou aralkyle pouvant être substitué ;

b) un composé à action réticulante, contenant au moins deux groupes réactifs, susceptibles de réagir sous l'effet de la chaleur avec des groupes —COOH avec formation d'une liaison chimique covalente ;

c) au moins un catalyseur capable d'accélérer la réaction du composé à action réticulante (b) avec les groupes —COOH, ainsi qu'éventuellement

d) des additifs et(ou) adjuvants usuels,

caractérisé en ce qu'il contient en tant que composant (c) au moins un catalyseur présent sous une forme bloquée, non active, qui peut être activée par voie photochimique par la lumière actinique et(ou) par voie thermique.

2. Matériau d'enregistrement photosensible suivant la revendication 1, caractérisé en ce que le catalyseur (c) bloqué, activable par voie photo-chimique et(ou) thermique, répond à la formule générale (II)

$$Y^{\oplus}A^{\ominus} \qquad (II)$$

dans laquelle $A^{\ominus}$ représente un anion tétrafluoroborate, hexafluorophosphate, hexafluor-antimoniate, hexafluorarséniate, hexachlor-antimoniate, hydroxy-pentafluorantimoniate ou hydroxy-pentachlor-antimoniate et $Y^{\oplus}$ un contre-cation adéquat.

3. Matériau d'enregistrement photosensible suivant la revendication 2, caractérisé en ce que la couche photosensible durcissable (S) contient comme composant (c) un catalyseur bloqué, activable par voie photochimique et(ou) thermique, de la formule générale (II), dans laquelle $Y^{\oplus}$ représente un ion aryl-diazonium de la formule générale (III)

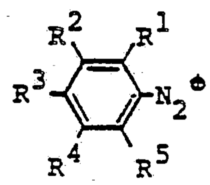

(III)

dans laquelle les substituants $R^1$ à $R^5$ désignent chacun, indépendamment les uns des autres, un atome d'hydrogène ou un groupe alkyle, cyclohexyle, phényle, alcoxy, aryl-thio, alkyl-thio ou amino di-substitué.

4. Matériau d'enregistrement photosensible suivant la revendication 2, caractérisé en ce que la couche photosensible durcissable (S) contient comme composant (c) un catalyseur bloqué, activable par voie photo-chimique et(ou) thermique, de la formule générale (II), dans laquelle $Y^{\oplus}$ représente un ion iodonium de la formule générale (IV)

$$[(R^6)_a I]^{\oplus} \qquad (IV)$$

dans laquelle $R^6$ désigne un groupe organique aromatique mono- ou bi-valent et a = 2, si $R^6$ = groupe aromatique mono-valent, ou a = 1, lorsque $R^6$ = groupe aromatique bi-valent.

5. Matériau d'enregistrement photosensible suivant la revendication 2, caractérisé en ce que, dans le catalyseur (c) de la formule générale (II), $Y^{\oplus}$ représente un ion pyrylium de la formule générale (V)

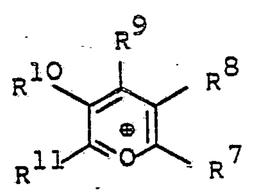

(V)

dans laquelle les substituants $R^7$ et $R^{11}$ désignent chacun un radical alkyle ou alcaryle en $C_1$ à $C_8$ et les substituants $R^8$, $R^9$ et $R^{10}$, indépendamment l'un de l'autre, un atome d'hydrogène, un radical alkyle, alkaryle ou cycloalkyle avec jusqu'à huit atomes de carbone, un groupe phényle, naphtyle, indényle, indanyle ou fluorényle éventuellement alkyl-substitué ou un groupe hétérocyclique, comprenant un ou deux hétéro-atomes.

6. Matériau d'enregistrement photosensible suivant la revendication 2, caractérisé en ce que, dans le catalyseur de la formule générale (II), $Y^{\oplus}$ représente un cation de la formule générale (VI)

$$[(R^{12})_b(R^{13})_c(R^{14})_d S]^{\oplus} \qquad (VI)$$

dans laquelle $R^{12}$ désigne un groupe organique aromatique mono-valent, $R^{13}$ un groupe organique aromatique bi-valent et $R^{14}$ un radical alkyle éventuellement substitué ou cycloalkyle, b étant un nombre entier entre 0 et 3, c valant 0 ou 1 et d étant un nombre entier entre 0 et 2, avec la condition que la somme $b + 2c + d = 3$.

7. Matériau d'enregistrement photosensible suivant la revendication 2, caractérisé en ce que, dans le catalyseur (c) de la formule générale (II), $Y^{\oplus}$ représente un cation de la formule générale (VII)

$$[R(^{12})_e(R^{13})_f(R^{15})_g Z]^{\oplus} \qquad (VII)$$

dans laquelle $R^{12}$ désigne un groupe organique aromatique mono-valent, $R^{13}$ un groupe organique aromatique bi-valent et $R^{15}$ un groupe alkyle, alcoxy, aryloxy, cycloalkyle ou phénacyle éventuellement substitué, Z représente un élément du 5ᵉ groupe du Système périodique, e étant un nombre entier entre 0 et 4, f un nombre entier entre 0 et 2 et g un nombre entier entre 0 et 2 avec la condition que la somme $e + 2f + g = 4$.

8. Matériau d'enregistrement photosensible suivant la revendication 2, caractérisé en ce que, dans le catalyseur (c) de la formule générale (II), $Y^{\oplus}$ représente un cation de la formule générale (VIII)

$$[(R^{16})_h(R^{17})_j(R^{18})_kS(O)]^{\oplus} \qquad (VIII)$$

dans laquelle $R^{16}$ désigne un groupe alkyle, aryle, cycloalkyle, cycloalkyl-alkyle ou arylalkyle, $R^{17}$ un groupe carbamoyl-méthyle, acyl-méthyle ou aroyl-méthyle éventuellement substitué et $R^{18}$ un radical alcoxy ou aryloxy, tandis que h est un nombre entier entre 0 et 3, j un nombre entier entre 0 et 3 et k un nombre entier entre 0 et 3 avec la condition que la somme $h + j + k = 3$.

9. Matériau d'enregistrement photosensible suivant l'une des revendications 1 à 8, caractérisé en ce que la couche photosensible durcissable (S) contient entre 0,05 et 20 % de son poids d'un ou de plusieurs catalyseurs (c) bloqués, activables par voie photo-chimique et(ou) thermique.

10. Matériau d'enregistrement photosensible suivant l'une des revendications 1 à 9, caractérisé en ce que la couche photosensible durcissable (S) contient un composé, en particulier une substance polymère, dont la molécule comprend simultanément des groupements ester d'ortho-nitro-carbinol de la formule générale (I) et des groupes à action réticulante, susceptibles de réagir avec les groupes —COOH.

11. Matériau d'enregistrement photosensible suivant la revendication 10, caractérisé en ce que le composé contenant les groupements ester d'ortho-nitro-carbinol de la formule (I) comprend aussi des groupes amino, imino, amide, époxy ou hydroxy.

12. Matériau d'enregistrement photosensible suivant l'une des revendications 1 à 9, caractérisé en ce que la couche photosensible durcissable (S) contient en outre, à côté des groupements ester d'ortho-nitro-carbinol de la formule (I), un ou plusieurs composés à action réticulante avec au moins deux groupes réactifs du genre défini.

13. Matériau d'enregistrement photosensible suivant la revendication 12, caractérisé en ce que la couche photosensible durcissable (S) contient en tant que composés à action réticulante des époxydes, des alcools et(ou) des amines.